# EUROPEAN PATENT SPECIFICATION

(11) **EP 4 209 315 B1**
(45) Date of publication and mention of the grant of the patent: **30.09.2026**
(21) Application number: 21864571.1
(22) Date of filing: 20.08.2021
(51) Int. Cl.: G05D 1/00, B25J 11/00, B25J 9/16, B25J 19/00, B25J 19/02, G05D 1/24

(54) **MOBILE ROBOT AND SEMICONDUCTOR MAGAZINE OPERATION SYSTEM USING MOBILE ROBOT**
MOBILER ROBOTER UND HALBLEITERMAGAZINBETRIEBSSYSTEM MIT DEM MOBILEN ROBOTER
ROBOT MOBILE ET SYSTÈME DE FONCTIONNEMENT DE SYSTÈME DE STOCKAGE DE SEMI-CONDUCTEURS FAISANT APPEL À UN ROBOT MOBILE

(30) Priority: 01.09.2020 KR 20200110977; 01.09.2020 KR 20200111000
(43) Date of publication of application: 12.07.2023
(73) Proprietor: LG Innotek Co., Ltd., Seoul 07796 (KR)
(72) Inventor: YANG, Hyae Sik, Seoul 07796 (KR); PARK, Se Hong, Seoul 07796 (KR); LEE, Seung Hyeon, Seoul 07796 (KR)
(74) Representative: DREISS Patentanwälte PartG mbB
(86) International application number: PCT/KR2021/011127
(87) International publication number: WO 2022/050610

(56) References cited:
- WO-A1-2005/036292
- AU-A1- 2011 352 997
- KR-A- 20150 001 220
- KR-A- 20170 006 397
- KR-A- 20190 068 786
- KR-A- 20200 057 321
- US-A1- 2017 173 796

## Description

### [Technical Field]

An embodiment relates to a mobile robot.

### [Background Art]

WO 2005/036292 A1 discloses a mobile robot according to the preamble of claim 1. An automated manufacturing method in which most of the work processes are automatically handled by the machine itself is called an automation process, the automation process includes an automatic measurement system that automatically measures the size, shape, quality, etc. of a workpiece or part in a manufacturing line, a factory automation that automates and unmanned the system of the manufacturing line, or a logistics automation that automatically transfers goods from the manufacturing line.

Such the automation system is applied in all industrial fields, and may be essential in an automation system of a semiconductor manufacturing line in particular. An unmanned guided vehicle was introduced for this automation system.

In general, as the unmanned guided vehicle is a transport means for transporting and supplying parts by unmanned, the unmanned guided may be applied to supply transported materials such as parts to each process in an automated production line or to perform a transport operation for warehousing of finished products.

The automatic guided vehicle moves while being operated under the control of a control program generally determined for the transfer work or the like. In addition, since the automatic guided vehicle runs automatically without a driver, a detecting means capable of detecting the location information of the obstacle is provided when there is an obstacle in front, and thus, since the driving direction and speed are controlled using the detected location information, safety accidents such as collisions with obstacles can be prevented.

Meanwhile, recently, a process of unmanning a manufacturing line by a mobile robot combining an unmanned guided vehicle and a cooperative robot has been attempted.

At this time, the movement of the automatic guided vehicle may be restricted due to the limitation of obstacle detection of the automatic guided vehicle, and errors in the manufacturing process may occur due to the precision of the cooperative robot, thereby reducing process efficiency.

Therefore, the mobile robot having a new structure capable of solving the above problems is required.

### [Disclosure]

### [Technical Problem]

An embodiment relates to a mobile robot that is easy to move and has improved process precision.

### [Technical Solution]

The invention is as defined in claim 1.

### [Advantageous Effects]

The mobile robot according to the embodiment may sense obstacles of a horizontal direction and a vertical direction disposed on a movement path of the mobile robot when the mobile robot moves by a first sensor member and a second sensor member.

Accordingly, since the mobile robot can sense the obstacles of the horizontal direction and the vertical direction disposed on the movement path of the mobile robot, the movement path of the mobile robot is lengthened, and process efficiency can be improved.

Also, the mobile robot according to the embodiment may control the position of the mobile robot by a third sensor member when the mobile robot moves. That is, after the mobile robot moves to a process facility and is stopped, alignment errors in horizontal and vertical directions between the mobile robot and the process facility may be controlled before the process proceeds.

Accordingly, the mobile robot may improve process precision of a work member by minimizing an alignment error between the mobile robot and the process facility.

In addition, the mobile robot according to the embodiment may improve precision of the work robot by a fourth sensor member when the mobile robot moves.

That is, the fourth sensor member can minimize an alignment error between the grip part of the work robot and the magazine, and accordingly, the grip part can stably grip the magazine to load and unload the magazine.

Accordingly, the mobile robot may improve movement precision and stability of the magazine by the work robot.

In addition, the mobile robot according to the embodiment may prevent the mobile robot from being discharged during work. That is, since the mobile robot is charged simultaneously with the operation of the mobile robot, it is possible to prevent the mobile robot from being discharged while moving or working, thereby improving process efficiency.

Since the discharge of the mobile robot may be prevented during the process of the mobile robot, the mobile robot may have improved process efficiency.

### [Description of Drawings]

FIG 1 is a perspective view of a mobile robot according to an embodiment.
FIS. 2 is a view for explaining a first sensor member of the mobile robot according to the embodiment.
FIG 3 is a view for explaining a third sensor member of the mobile robot according to the embodiment.
FIG 4 is another perspective view of the mobile robot according to the embodiment.
FIG 5 is a view for explaining a brief process flow chart of a semiconductor magazine operation system according to the embodiment.
FIG 6 is a view for explaining a process flow chart in a first process facility of the semiconductor magazine operation system according to the embodiment.
FIG 7 is a view for explaining a docking process of the mobile robot and the first process facility in the semiconductor magazine operation system according to the embodiment.
FIG 8 is a view for explaining a process flow chart according to a fourth sensor member in the semiconductor magazine operation system of FIG 7.
FIG 9 is a view for explaining a process flow chart according to a work robot in the semiconductor magazine operation system of FIG 7.
FIG 10 is a view for explaining a process flow chart in a second process facility of the mobile robot according to the embodiment.
FIG 11 is a view for explaining a process flow chart according to the work robot in the semiconductor magazine operation system of FIG 10.
FIG 12 is a view for explaining a process flow chart in a third process facility of the mobile robot according to the embodiment.
FIG 13 is a view for explaining a flow chart of a charging process of the mobile robot according to the embodiment.

### [Modes of the Invention]

Hereinafter, embodiments of the present invention will be described in detail with reference to the accompanying drawings.

In addition, unless expressly otherwise defined and described, the terms used in the embodiments of the present invention (including technical and scientific terms) may be construed the same meaning as commonly understood by one of ordinary skill in the art to which this invention belongs, and the terms such as those defined in commonly used dictionaries may be interpreted as having a meaning that is consistent with their meaning in the context of the relevant art.

In addition, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present invention, the terms such as first, second, A, B, (a), and (b) may be used. These terms are only used to distinguish the elements from other elements, and the terms are not limited to the essence, order, or order of the elements.

In addition, when an element is described as being "connected", or "coupled" to another element, it may include not only when the element is directly "connected" to, or "coupled" to other elements, but also when the element is "connected", or "coupled" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

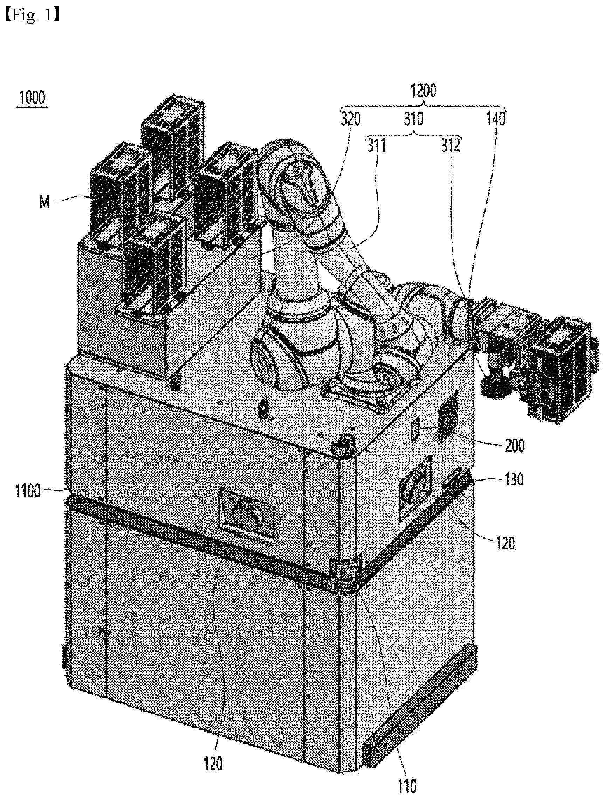

FIG 1 is a perspective view of a mobile robot according to an embodiment.

Referring to FIG 1, the mobile robot 1000 according to the embodiment includes a transport member 1100 and a work member 1200.

The transport member 1100 is disposed below the mobile robot 1000, and the work member 1200 is disposed above the mobile robot 1000. That is, the work member 1200 is disposed above the transport member 1100. That is, the work member 1200 is disposed above the transport member 1100 and combined with the transport member 1100.

The mobile robot 1000 moves by the transport member 1100. In detail, after a semiconductor magazine in which a process has been completed or a semiconductor magazine to be processed is loaded or unloaded by the work member 1200, the transport member 1100 is moved by the mobile robot 1000 to each process facility that is being processed through the work member 1200.

For example, the transport member 1100 may be a laser guided vehicle LGV.

Meanwhile, the mobile robot 1000 may be moved to each process facility at each stage by the transport member 1100. At this time, a plurality of sensor members may be disposed on the transport member 1100 to prevent a collision of the mobile robot 1000 with an obstacle located in a movement path of the mobile robot 1000.

The transport member 1100 may include a plurality of surfaces. In detail, the transport member 1100 may include a lower surface, an upper surface opposite to the lower surface, and a plurality of side surfaces connecting the lower surface and the upper surface. The side surfaces may include a first side surface, a second side surface, a third side surface and a fourth side surface connected to each other.

The transport member 1100 may move the mobile robot 1000 in a forward direction of the first side surface, a rear direction of the fourth side surface, a left direction of the second side surface, and a right direction of the third side surface.

A moving member for moving the transport member 1100 may be disposed on a lower surface of the transport member 1100. The moving member may include various moving means such as wheel for moving the transport member 1100.

The work member 1200 may be disposed on an upper surface of the transport member 1100.

A sensor member may be disposed on at least one of the first side surface, the second side surface, the third side surface, and the fourth side surface of the transport member 1100. In detail, a plurality of sensor members may be disposed on the first side surface, the second side surface, the third side surface, and the fourth side surface of the transport member 1100.

The sensor member includes a first sensor member 110 and a second sensor member 120.

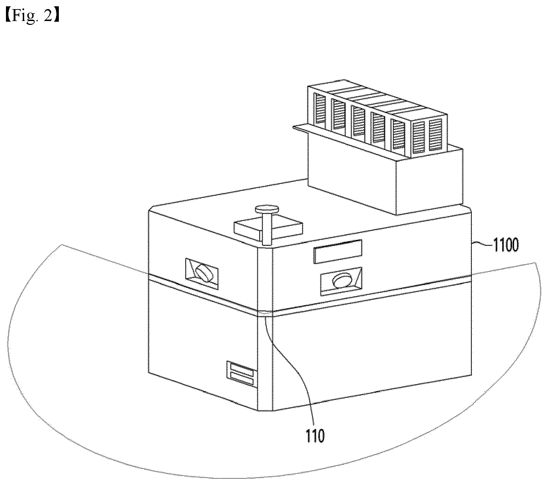

Referring to FIG 2, the first sensor member 110 may be disposed on a side surface of the transport member 1100. In detail, the transport member 1100 may include a first connection surface connecting the first side surface and the second side surface, and a second connection surface connecting the first side surface and the third side surface.

The first sensor member 110 may be disposed on the first connection surface and the second connection surface. That is, at least two or more first sensor members 110 may be disposed on the transport member 1100.

The first sensor member 110 senses an obstacle disposed in a moving path of the mobile robot 1000 when the mobile robot 1000 moves. In detail, the first sensor member 110 senses an obstacle in a horizontal direction of the mobile robot 1000 when the mobile robot 1000 moves.

The first sensor member 110 may include a lidar sensor. The lidar sensor may sense an obstacle in the horizontal direction of the mobile robot by the principle of emitting a laser pulse, receiving the reflected light from a surrounding target object, and measuring a distance to the object.

The first sensor member 110 may detect an obstacle in a horizontal direction within a range of 270° or less of the transport member 1100, that is, the mobile robot 1000. That is, the first sensor member 110 may detect an obstacle in a horizontal direction of 180° to 270° of the mobile robot 1000.

Also, the first sensor member 110 may detect an obstacle spaced apart from the mobile robot 1000 at a distance of 25 m or less. In detail, the first sensor member 110 may detect an obstacle spaced apart from the mobile robot 1000 at a distance of 0.05 m to 25 m. In more detail, the first sensor member 110 may detect an obstacle spaced apart from the mobile robot 1000 at a distance of 1 m to 20 m.

When the mobile robot 1000 is moved by the transport member 1100, the first sensor member 110 detects obstacles in the horizontal direction disposed on the movement path of the mobile robot 1000 in advance, and collides with the obstacle may prevent while moving to each process facility.

Meanwhile, since the first sensor member 110 senses only obstacles in the horizontal direction of the mobile robot 1000, the first sensor member 110 cannot sense obstacles disposed in the vertical direction of the mobile robot 1000. Accordingly, the mobile robot according to the embodiment may further include a sensor member capable of sensing an obstacle in a vertical direction of the mobile robot 1000.

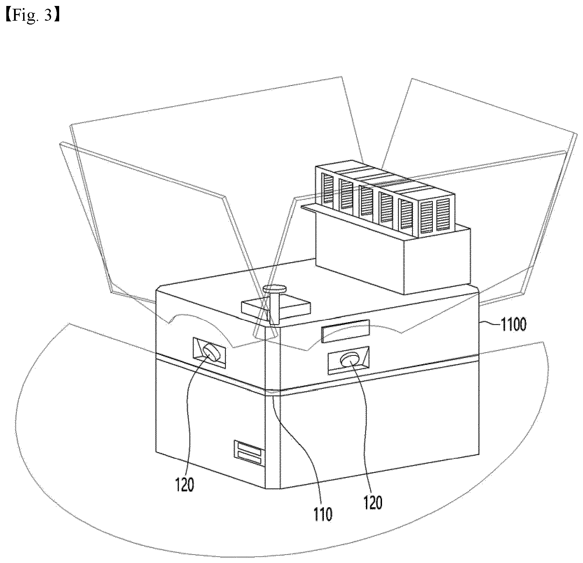

Referring to FIG 3, the second sensor member 120 may be disposed on a side surface of the transport member 1100.

The second sensor member 120 may be respectively disposed on the first side, the second side, the third side, and the fourth side of the transport member 1100. That is, at least four second sensor members 120 may be disposed on the transport member 1100.

The second sensor member 120 is disposed apart from the first sensor member 110.

The second sensor member 120 senses an obstacle disposed in a moving path of the mobile robot 1000 when the mobile robot 1000 moves. In detail, the second sensor member 120 senses an obstacle in a vertical direction of the mobile robot 1000 when the mobile robot 1000 moves.

The second sensor member 120 may include a laser distance sensor. The laser distance sensor senses a surrounding object by measuring a distance with a laser, the laser distance sensor rotates 360° and shoots a laser and measures the time it takes for the laser to be reflected and returned to a wall or an obstacle to sense an obstacle in the vertical direction of the mobile robot.

The second sensor member 120 may detect an obstacle in a vertical direction within a 360° range of the transport member 1100, that is, the mobile robot 1000. That is, the second sensor member 120 may detect an obstacle in a vertical direction in all directions of the mobile robot 1000.

That is, the mobile robot 1000 may sense obstacles in vertical directions in forward, backward, left, and right directions of the mobile robot 1000 by the second sensor member 120.

Also, the second sensor member 120 may detect an obstacle spaced apart from the mobile robot 1000 at a distance of 16 m or less. In detail, the second sensor member 120 may detect an obstacle spaced apart from the mobile robot 1000 at a distance of 0.1 m to 16 m. In more detail, the second sensor member 120 may detect an obstacle spaced apart from the mobile robot 1000 at a distance of 1 m to 10 m.

When the mobile robot 1000 is moved by the transport member 1100, the second sensor member 120 detects obstacles in the vertical direction disposed on the movement path of the mobile robot 1000 in advance, and collides with the obstacle may prevent while moving to each process facility.

The mobile robot 1000 may move to a facility suitable for each process while sensing an obstacle on a movement path by the first sensor member 110 and the second sensor member 120 described above.

At this time, the process facility and the mobile robot 1000 may be separated from each other by a predetermined distance, and the process may be performed. That is, in order to prevent an impact caused by a collision between the mobile robot 1000 and the process facility in the process space of the work member 1200, the process facility and the mobile robot 1000 may be spaced apart from each other and the process may be performed.

In addition, for the work precision of the mobile robot 1000, the mobile robot 1000 should have a small alignment error in the horizontal direction (X-axis direction) and vertical direction (Y-axis direction) with respect to the process facility.

Accordingly, the mobile robot 1000 may further include an additional sensor member for positioning accuracy of the mobile robot 1000 with respect to the process facility.

Referring to FIGS. 2 and 3, a third sensor member 130 may be disposed on a side surface of the transport member 1100.

In detail, the third sensor member 130 may be disposed on at least one of the first side surface, the second side surface, the third side surface, and the fourth side surface of the transport member 1100. In more detail, the third sensor 130 member may be disposed on any one side surface of the first side surface, the second side surface, the third side surface, and the fourth side surface of the transport member 1100. That is, the third sensor member130 may be disposed on a side surface of the transport member 1100 facing the process facility. For example, the third sensor member 130 may be disposed on the first side surface of the transport member 1100.

The third sensor member 130 may be disposed apart from the first sensor member 110 and the second sensor member 120.

The third sensor member 130 may control positions of the mobile robot 1000 and the process facility before the mobile robot 1000 moves to the process facility and a process is performed. In detail, the third sensor member 130 may control horizontal and vertical alignment of the mobile robot 1000 and the process facility before the mobile robot 1000 moves to the process facility and the process proceeds.

The third sensor member 130 may include a camera or a QR code. For example, the third sensor member 130 may include a vision camera or a QR code.

The third sensor member 130 may control the location of the mobile robot 1000 by aligning the center coordinates of the image acquired by the vision camera or the QR code with the center coordinates of the process facility.

In detail, the position of the mobile robot 1000 may be controlled such that an alignment error between the center coordinates of the third sensor member 130 and the center coordinates of the process facility is 40 mm or less.

Meanwhile, the mobile robot 1000 may further include a communication unit 200 for moving of the transport member 1100, driving of the first sensor member 110, the second sensor member 120, and the third sensor member 130, and communicating between the mobile robot 1000 and process facility.

The communication unit 200 may be disposed on a side surface of the transport member 1100. In detail, the communication unit 200 may be disposed on at least one of the first side surface, the second side surface, the third side surface, and the fourth side surface of the transport member 1100. In more detail, the communication unit 200 may be disposed on any one of the first side surface, the second side surface, the third side surface, and the fourth side surface of the transport member 1100. For example, the communication unit 200 may be disposed on the first side surface of the transport member 1100.

The communication unit 200 may be driven by a parallel input output communication interface.

The mobile robot 1000 may determine the state of the process facility by the communication unit 200, move to a process facility suitable for each step, and perform a work process.

The mobile robot according to the embodiment may sense obstacles of the horizontal direction and the vertical direction disposed on the movement path of the mobile robot when the mobile robot moves by the first sensor member and the second sensor member.

Accordingly, since the mobile robot can sense the obstacles of the horizontal direction and the vertical direction disposed on the movement path of the mobile robot, the movement path of the mobile robot is lengthened, and process efficiency can be improved.

Also, the mobile robot according to the embodiment may control the position of the mobile robot by the third sensor member when the mobile robot moves. That is, after the mobile robot moves to a process facility and is stopped, alignment errors in horizontal and vertical directions between the mobile robot and the process facility may be controlled before the process proceeds.

Accordingly, the mobile robot may improve process precision of the work member by minimizing an alignment error between the mobile robot and the process facility.

Hereinafter, the work member 1200 will be described with reference to FIG 1.

Referring to FIG 1, the work member 1200 includes a work robot 310, a magazine accommodating part 320, and a fourth sensor member 140.

The magazine accommodating part 320 may accommodate a semiconductor magazine M for which a process has been completed and a semiconductor magazine M to be processed.

The work robot 310 may be disposed above the transport member 1100. The work robot 310 may move the magazine M disposed in the magazine accommodating part 320 to the process facility or move the magazine M where the process is completed in the process facility to the magazine accommodating part 320.

The work robot 310 may include a cooperative robot. In detail, the work robot 310 may include an articulated collaborative robot.

In detail, the work robot 310 includes a joint part 311 and a grip part 312.

That is, the work robot 310 may move the position of the grip part 312 in the direction of the magazine by the joint part 311 and grip the magazine by the grip part 312.

At this time, depending on the position of the grip part 312, the grip precision of the magazine may vary. That is, as an alignment error between the grip part 312 and the magazine increases, grip precision by the grip part 312 may decrease.

Accordingly, the work member 1200 includes the fourth sensor member 140 for positional accuracy of the work robot 310 performing loading and unloading of the magazine.

The fourth sensor member 140 is combined with the work robot 310. In detail, the fourth sensor member 140 is combined with the work robot 310 and improves the positional accuracy of the work robot 310.

In detail, when the grip part 312 of the work robot 310 grips the magazine, the fourth sensor member 140 controls alignment in the horizontal and vertical directions of the grip part 312 and the magazine.

The fourth sensor member 140 may include a camera. In detail, the fourth sensor member 140 may include a vision camera.

It is confirmed whether the vision marker of the process facility is recognized within the field of view of the vision camera, and then, alignment errors may be controlled by correcting center coordinates of the X and Y axes based on the center coordinates measured by the fourth sensor member and the center point of the vision marker.

In detail, the fourth sensor member 140 may control the alignment of the grip part 312 and the magazine so that the center coordinate of the fourth sensor member 140 and the center coordinate of the vision marker of the process facility are 1 mm or less. In more detail, the fourth sensor member may control the alignment of the grip part 312 and the magazine so that the center coordinate of the fourth sensor member 140 and the center coordinate of the vision marker of the process facility are 0.08 mm or less.

The mobile robot 1000 according to the embodiment may improve precision of the work robot by the fourth sensor member when the mobile robot moves.

That is, the fourth sensor member can minimize an alignment error between the grip part of the work robot and the magazine, and accordingly, the grip part stably grips the magazine to load and unload the magazine.

Accordingly, the mobile robot may improve movement precision and stability of the magazine by the work robot.

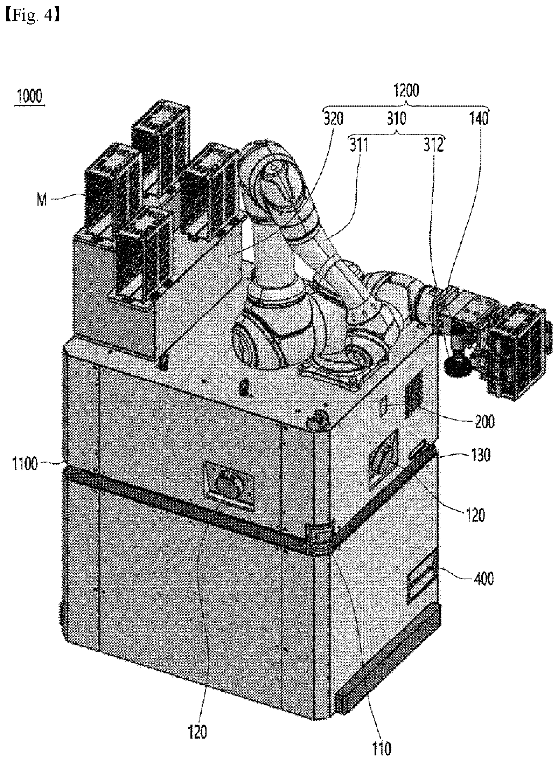

Hereinafter, a mobile robot according to another embodiment will be described with reference to FIG 4. In the description of the mobile robot according to another embodiment, the same reference numerals are assigned to the same compositions, and the same or similar contents to those of the mobile robot described above will not be described.

Referring to FIG 4, the mobile robot according to another embodiment may further include a charging unit 400.

In detail, the charging unit 400 may be disposed on at least one of the first side surface, the second side surface, the third side surface, and the fourth side surface of the transport member 1100. In more detail, the charging unit 400 may be disposed on any one of the first side surface, the second side surface, the third side surface, and the fourth side surface of the transport member 1100. That is, the charging unit 400 may be disposed on a side surface of the transport member 1100 facing the process facility. For example, the charging unit 400 may be disposed on the first side surface of the transport member 1100.

The charging unit 400 may be disposed to be spaced apart from the first sensor member 110, the second sensor member 120, and the third sensor member 130.

The charging unit 400 may charge the mobile robot 1000 when the mobile robot 1000 moves to the process facility and a process is performed. In detail, the mobile robot 1000 may be connected to a charging terminal of the process facility after being moved to and fixed to the process facility.

Accordingly, charging of the mobile robot 1000 may be performed at the same time as the mobile robot is working.

Therefore, the mobile robot 1000 according to the embodiment can prevent the mobile robot 1000 from being discharged during work. That is, since the mobile robot 1000 is charged simultaneously with the operation of the mobile robot 1000, it is possible to prevent the mobile robot 1000 from being discharged while moving or working, and thus, it is possible to have improved process efficiency.

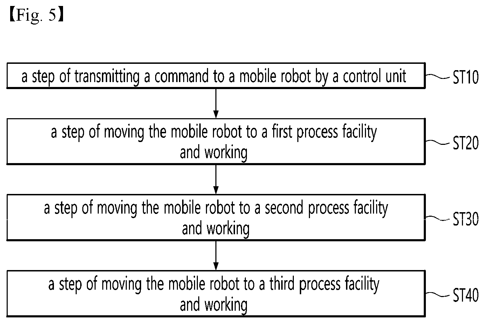

Hereinafter, a semiconductor magazine operating system according to an embodiment will be described in detail with reference to FIGS. 5 to 13.

FIG 5 is a view for explaining a brief process flow chart of a semiconductor magazine operation system according to the embodiment.

Referring to FIG 5, the semiconductor magazine operation system transmits a command from a control unit to a mobile robot ST10, moves the mobile robot to a first process facility and performs work ST20, moves the mobile robot to a second process facility and performs work ST30, and moves the mobile robot to a third process facility and performs work ST40.

In detail, the first process facility may be an input stocker in which a magazine is accommodated before operation, the second process facility may be a magazine operation facility, and the third process facility may be an output stocker in which a magazine is accommodated after operation.

Accordingly, in the semiconductor magazine operation system, in the first process facility, the mobile robot moves the magazine before work to the magazine accommodating part of the mobile robot, and the mobile robot moves the magazine of the magazine accommodating part to the second process facility, and the magazine that has completed the work in the second process facility moves to the magazine accommodating part of the mobile robot, and then in the third process facility, the magazine on which the work is completed may be moved.

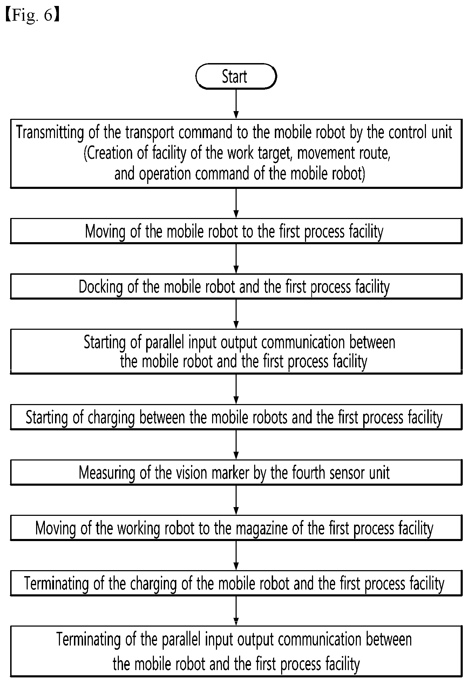

Hereinafter, a step ST20 in which the mobile robot moves to the first process facility to work, a step ST30 in which the mobile robot moves to the second process facility to work, and a step ST30 in which the mobile robot moves to the third process facility to work are explained in detail with reference to FIGS. 6 to 12.

Referring to FIG 6, in the step ST20 of moving the mobile robot to the first process facility and working, a command may be transmitted from the control unit to the mobile robot. In detail, a control unit of the mobile robot may transmit a process facility of the work target of the semiconductor magazine, a movement route, and an operation command of the mobile robot in the process facility to the mobile robot.

Subsequently, the mobile robot receiving the command from the control unit may move to the first process facility. The first process facility is a facility for accommodating a semiconductor before work, that is, a semiconductor magazine in which work is to be performed.

Subsequently, the mobile robot and the first process facility may be docked. That is, the mobile robot moved to the first process facility may be combined with the first process facility.

In the step of docking the mobile robot and the first process facility, a process for aligning the mobile robot and the first process facility may be performed. The alignment process will be described in detail with reference to FIG 4 below.

Then, the mobile robot and the first process facility may initiate parallel input output communication. The communication may be performed by the communication unit 200 of the mobile robot described above.

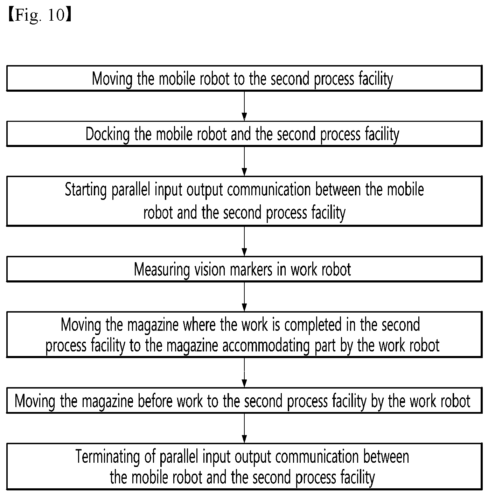

Subsequently, the mobile robot may be charged through the first process facility. Charging of the mobile robot will be described in detail with reference to FIG 10 below.

Subsequently, after recognizing the fourth sensor member 140 of the mobile robot and the vision marker of the first process facility, the work robot of the mobile robot moves to the semiconductor magazine in the first process facility, and the semiconductor magazine may be moved to the magazine accommodating part of the mobile robot by the work robot.

At this time, an alignment process may be performed by the fourth sensor member of the mobile robot for work precision of the work robot.

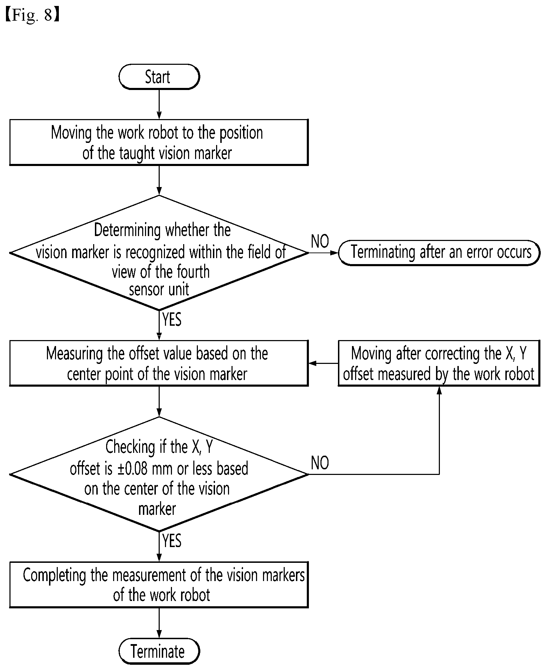

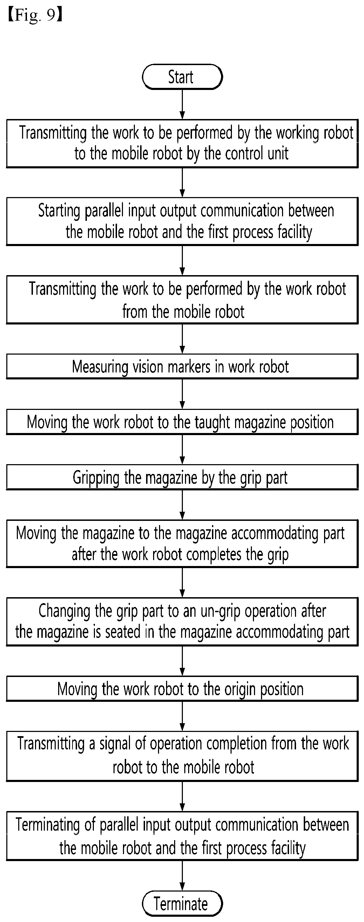

The alignment process will be described in detail with reference to FIGS. 8 and 9 below.

Subsequently, charging of the mobile robot and the first process facility is terminated. Subsequently, parallel input output communication between the mobile robot and the first process facility may be terminated, and work between the mobile robot and the first process facility may be terminated.

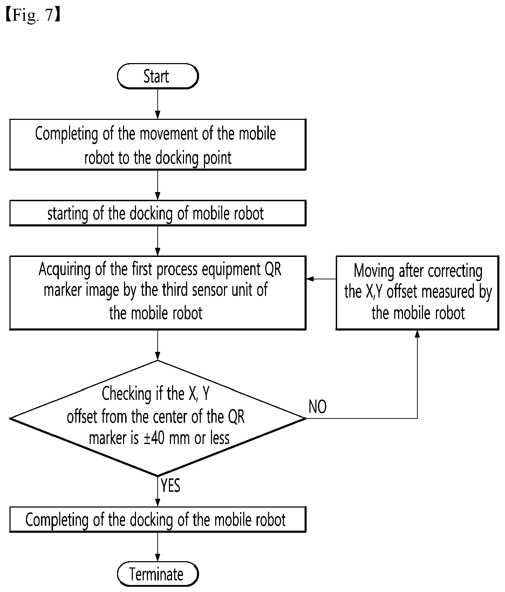

Hereinafter, a docking process and an align process between the mobile robot and the first process facility will be described in detail with reference to FIGS. 7 to 9.

FIG 7 is a flow chart illustrating a docking process between the mobile robot and the first process facility.

First, the mobile robot may be moved to a point where it is docked with the first process facility. The movement of the mobile robot may be performed by a command transmitted from the control unit described above.

Subsequently, the mobile robot may stop moving and start docking with the first process facility.

Subsequently, an alignment process between the mobile robot and the first process facility may be performed. Alignment of the docking process between the mobile robot and the first process facility may be performed by the third sensor member 130 of the mobile robot described above.

In detail, the step of acquiring the image of the QR mark of the first process facility by the third sensor member 130 of the mobile robot may proceed. After the mobile robot acquires the image of the first process facility, it may compare offsets of the X and Y axes measured by the third sensor member 130 with the center of the image. That is, the center coordinates of the third sensor member and the center coordinates of the QR image may be compared.

At this time, when the error between the center coordinate of the third sensor member and the center coordinate of the QR image exceeds ±40 mm, after correcting the position of the mobile robot, the center coordinate of the third sensor member and the center coordinate of the QR image may be compared again.

In addition, when the error between the center coordinate of the third sensor member and the center coordinate of the QR image is ±40 mm or less, the mobile robot and the first process facility may be docked.

In the semiconductor magazine operation system according to the embodiment, since a process capable of reducing alignment errors is added when the mobile robot and the first process facility are docked, the first process facility and the mobile robot may be precisely docked, and work precision that proceeds after docking may be improved.

FIGS. 8 and 9 are flowcharts illustrating a step of moving the semiconductor magazine in the first process facility by the mobile robot. In detail, FIG 8 is a flowchart illustrating an alignment process between the work robot and the first process facility, FIG 9 is a flowchart illustrating a step of moving the semiconductor magazine of the first process facility by the work robot.

Referring to FIG 8, after docking of the mobile robot and the first process facility is completed, a step of moving the semiconductor magazine in the first process facility by the work robot may be performed.

First, the work robot may be moved to the teaching position of the vision marker of the first process facility. Teaching to the work robot may be determined by a command of the control unit.

Subsequently, the vision mark of the first process facility may be acquired by the fourth sensor member 140 coupled to the work robot. When the vision mark of the first process facility is not acquired by the fourth sensor member 140, the operation may end as a process error.

When the vision mark of the first process facility is acquired by the fourth sensor member 140, a step of comparing center coordinates of the fourth sensor member 140 and center coordinates of the vision mark may proceed. In detail, after the fourth sensor member 140 acquires the vision marker of the first process facility, the X-axis and Y-axis offsets measured by the fourth sensor member 140 may be compared with the center point of the vision marker. That is, the center coordinates of the fourth sensor member 140 and the center coordinates of the vision marker may be compared.

At this time, when the error between the center coordinates of the fourth sensor member and the center coordinates of the vision marker exceeds ±0.08 mm, after correcting the position of the work robot, the center coordinate of the fourth sensor member and the center coordinate of the vision marker may be compared again.

In addition, when the error between the center coordinates of the fourth sensor member and the center coordinates of the vision marker is ±0.08 mm or less, the comparison of the work robot and the vision markers of the first process facility may be completed.

In the semiconductor magazine operation system according to the embodiment, since a process capable of reducing alignment errors is added when the work robot moves to the semiconductor magazine of the first process facility, the work robot may be precisely moved and the precision of subsequent work may be improved.

FIG 9 is a flowchart of a step of moving the semiconductor magazine of the first process facility by the work robot including the alignment process.

First, an operation to be performed by the work robot may be transmitted to the mobile robot by the control unit.

Then, parallel input output communication between the mobile robot and the first process facility starts, whereby a command transmitted from a command unit may be transmitted from the mobile robot to the work robot.

Subsequently, as shown in FIG 5, an alignment process between the work robot and the first process facility may be performed in the work robot. Then, it may be moved to the taught position of the semiconductor magazine by the joint part of the work robot.

Subsequently, after gripping the semiconductor magazine by the grip part of the work robot, the semiconductor magazine may be moved to the magazine accommodating part of the mobile robot by the joint part of the work robot. Subsequently, after the semiconductor magazine is seated in the magazine accommodating part by the work robot, the grip part is changed from a gripping operation to an un-gripping operation, and the work robot may be moved to an origin position by the joint part.

Subsequently, the work robot transmits a signal to the mobile robot that the work has been completed, and as parallel input output communication between the mobile robot and the first process facility is terminated, the process between the mobile robot and the first process facility may be terminated.

In the semiconductor magazine operation system according to the embodiment, during the process of the mobile robot and the first process facility, the align process of the mobile robot and the first process facility and the alignment process of the work robot and the first process facility are performed together, a positional accuracy of the mobile robot and the work robot may be precisely controlled.

Accordingly, since the semiconductor magazine of the first process facility may be accurately moved to the magazine accommodating part of the mobile robot by the mobile robot, process precision and process efficiency may be improved.

FIG 10 is as view for explaining a step ST30 in which the mobile robot moves to and works in the second process facility.

Referring to FIG 10, in the step ST30 of moving the mobile robot to the second process facility to work, the control unit first transmits a command to the mobile robot so that the mobile robot may move to the second process facility. In detail, a control unit of the mobile robot may transmit a process facility of the work target of the semiconductor magazine, a movement route, and an operation command of the mobile robot in the process facility to the mobile robot. As described above, the second process facility is a facility where semiconductor magazine operations are performed.

Subsequently, the mobile robot and the second process facility may be docked. That is, the mobile robot moved to the second process facility may be combined with the second process facility.

The docking step of the mobile robot and the second process facility may also be performed in the same process as in FIG 3 described above. That is, the mobile robot may be docked with the second process facility at a precise position by the third sensor member.

Then, the mobile robot and the second process facility may start parallel input output communication. The communication may be performed by the communication unit 200 of the mobile robot described above.

Subsequently, after recognizing the fourth sensor member of the mobile robot and the vision marker of the second process facility, the semiconductor magazine of the second process facility, the work of which has been completed by the work robot of the mobile robot, is moved to the magazine accommodating part of the mobile robot, and a semiconductor magazine in which work is not performed, that is, a semiconductor magazine that has been moved from the first process facility to the magazine accommodating part may be moved to the second process facility.

A moving process of the semiconductor magazine will be described in detail with reference to FIG 8 below.

Subsequently, parallel input output communication between the mobile robot and the second process facility may be terminated, and work between the mobile robot and the second process facility may be terminated.

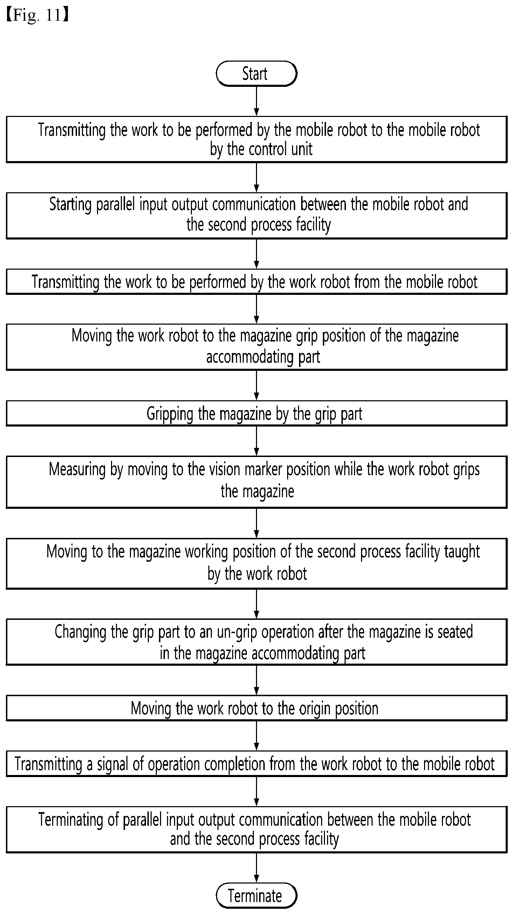

FIG 11 is a view illustrating in detail the process of moving the mobile robot and the semiconductor magazine in the second process facility described above.

Referring to FIG 11, first, a operation to be performed by the work robot may be transmitted to the mobile robot by the control unit.

Subsequently, parallel input output communication between the mobile robot and the second process facility is started, and thus, the command transmitted from the command unit may be transmitted from the mobile robot to the work robot.

Subsequently, the work robot may move to the magazine accommodating part of the mobile robot. Subsequently, the work robot may grip the semiconductor magazine in the magazine accommodating part.

Subsequently, the work robot may perform an alignment process with the second process facility while gripping the semiconductor magazine. That is, the work robot may move to the position of the vision mark of the second process facility and control the alignment of the work robot and the second process facility as described above in FIG 5.

Subsequently, the work robot may move the semiconductor magazine to the taught position of the semiconductor magazine by the joint part of the work robot.

Subsequently, after the work robot moves the semiconductor magazine to the second process facility, the grip part is changed from a gripping operation to an un-gripping operation, and the work robot may be moved to an origin position by the joint part.

Subsequently, the work robot transmits a signal to the mobile robot that the work has been completed, and as parallel input output communication between the mobile robot and the second process facility is terminated, the process between the mobile robot and the second process facility may be terminated.

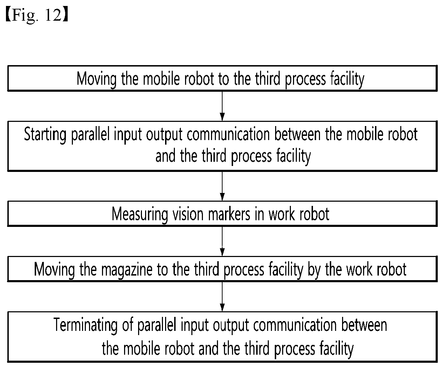

FIG 12 is as view for explaining a step ST40 in which the mobile robot moves to and works in the third process facility.

Referring to FIG 12, in the step ST40 of moving the mobile robot to the third process facility to work, the control unit first transmits a command to the mobile robot so that the mobile robot may move to the third process facility. In detail, a control unit of the mobile robot may transmit a process facility of the work target of the semiconductor magazine, a movement route, and an operation command of the mobile robot in the process facility to the mobile robot. As described above, the third process facility may be an output stocker in which a magazine is accommodated after work.

Then, the mobile robot and the third process facility may start parallel input output communication. The communication may be performed by the communication unit 200 of the mobile robot described above.

Subsequently, after recognizing the fourth sensor member 140 of the mobile robot and the vision marker of the third process facility, the work robot of the mobile robot may move the semiconductor magazine where the work is completed into the third process facility.

At this time, the alignment of the fourth sensor member and the third process facility may be performed in the same manner as the process of FIG 5 described above.

Subsequently, parallel input output communication between the mobile robot and the third process facility may be terminated, and work between the mobile robot and the third process facility may be terminated.

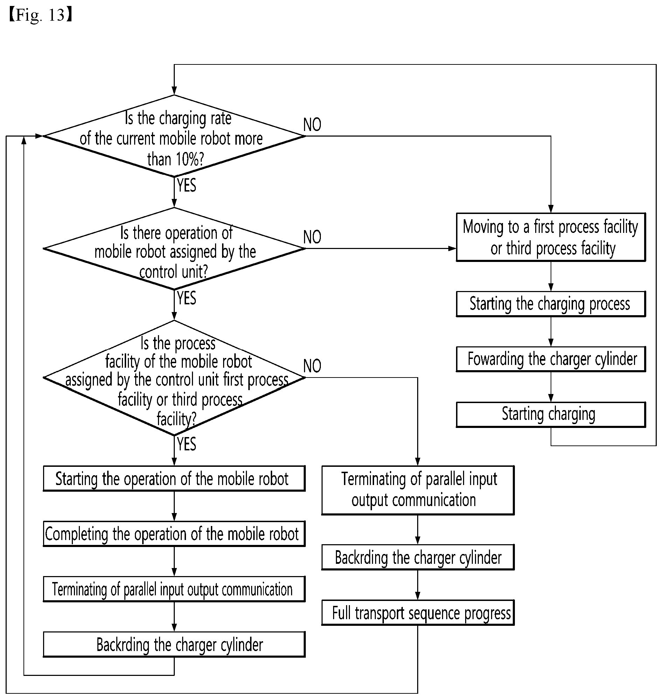

Next, referring to FIG 13, the charging step of the mobile robot will be described in detail.

Referring to FIG 13, in the charging step of the mobile robot, first, the charging rate of the mobile robot is measured. When the charging rate of the mobile robot is 10% or more, it moves to the first process facility or the third process facility, and the charging process is started in the first process facility and the third process facility. In detail, after moving the cylinders of the chargers of the first process facility and the third process facility forward, charging may be started by combining with the charging unit 400 of the mobile robot.

Alternatively, when the charging rate of the mobile robot is less than 10%, after determining whether or not the mobile robot is working by the control unit, if there is no assigned task, the mobile robot moves to the first process facility and the third process facility and starts the charging process as described above.

Alternatively, when the charging rate of the mobile robot is less than 10%, after determining whether there is operation of the mobile robot assigned by the control unit, when there is no assigned operation, the charging process starts as described above by moving to the first process facility and the third process facility.

Alternatively, when the charging rate of the mobile robot is less than 10%, after determining whether there is operation of the mobile robot assigned by the control unit, when the assigned operation is an operation in the first process facility and the third process facility, the mobile robot may be charged while moving to the first process facility or the third process facility and starting work.

Alternatively, when the charging rate of the mobile robot is less than 10%, after determining whether there is operation of the mobile robot assigned by the control unit, when the assigned operation is not an operation in the first process facility and the third process facility, the parallel input output communication of the mobile robot is terminated, the mobile robot is charged, and then the semiconductor magazine work system may proceed again.

In the semiconductor magazine operation system according to the embodiment, since the charging process may be performed simultaneously with the work, a separate process for charging the mobile robot is not required.

Therefore, since the discharge of the mobile robot may be prevented during the process of the mobile robot, the mobile robot may have improved process efficiency.

## Claims

1. A mobile robot (1000) comprising:
a transport member (1100); and
a work member (1200) disposed on the transport member (1100),
wherein the transport member (1100) includes a first sensor member (110) disposed on a side surface of the transport member (1100) and a second sensor member (120) spaced apart from the first sensor member (110),
wherein the first sensor member (110) senses an obstacle in a horizontal direction (X-axis direction) of the transport member (1100),
wherein the second sensor member (120) senses an obstacle in a vertical direction (Y-axis direction) of the transport member (1100),
**characterized in that**
the work member (1200) further includes a work robot (310), a magazine accommodating part (320), and a fourth sensor member (140) combined to the work robot (310),
wherein the magazine accomodation part (320) accommodates a magazine (M),
wherein the work robot (310) includes a joint part (311) and a grip part (312),
wherein the fourth sensor member (140) controls horizontal and vertical alignment of the grip part (312) and the magazine (M) when the grip part of the work robot (310) grips the magazine (M).

2. The mobile robot of claim 1, wherein the transport member (1100) incudes a first side surface, a second side surface, a third side surface, a fourth side surface, a first connection surface between the first side surface and the second side surface; and a second connection surface between the first side surface and the third side surface,
wherein the first sensor member (110) is disposed on the first connection surface and the second connection surface,
wherein the second sensor member (120) is disposed on the first side surface, the second side surface, the third side surface and the fourth side surface.

3. The mobile robot of claim 2, wherein the first sensor member (110) includes a lidar sensor, wherein the second sensor member (120) includes a laser distance sensor.

4. The mobile robot of claim 1, wherein the first sensor member (110) is configured to detect an obstacle
- in a horizontal plane of the mobile robot (1000), and
- within an angular range of 180° to 270° of the first sensor member (110).

5. The mobile robot of claim 1, wherein the first sensor member (110) is configured to detect an obstacle spaced apart from the mobile robot (1000) at a distance of 0.05 m to 25 m.

6. The mobile robot of claim 1, wherein the second sensor member (120) is configured to detect an obstacle
- in a vertical plane of the mobile robot (1000), and
- within an angular range of 0° to 360° of the second sensor member (120).

7. The mobile robot of claim 1, wherein the second sensor member (120) is configured to detect an obstacle spaced apart from the mobile robot (1000) at a distance of 0.1 m to 16 m.

8. The mobile robot of claim 1, further comprising a third sensor member (130) disposed on the first side surface of the transport member (1100) and controlling a position of the mobile robot (1000) such that an error between a center coordinates of the third sensor member (130) and a center coordinates of the facility is 40 mm or less.

9. The mobile robot of claim 8, wherein the third sensor member (130) is spaced apart from the first sensor member (110) and the second sensor member (120).

10. The mobile robot of claim 8, wherein the third sensor member (130) includes a vision camera or a QR code.

11. The mobile robot of claim 1, further comprising a communication unit (200) disposed on a side surface of the transport member (1100).

12. The mobile robot of claim 1, further comprising a charging unit (400) disposed on at least one side surface of the transport member (1100).

13. The mobile robot of claim 12, wherein the charging unit (400) is charged when the mobile robot (1000) moves to the process facility and performs a process.

## Patentansprüche

1. Mobiler Roboter (1000), umfassend:
ein Transportelement (1100); und
ein Arbeitselement (1200), das auf dem Transportelement (1100) angeordnet ist;
wobei das Transportelement (1100) ein erstes Sensorelement (110), das an einer Seitenoberfläche des Transportelements (1100) angeordnet ist, und ein zweites Sensorelement (120), das von dem ersten Sensorelement (110) beabstandet ist, einschließt,
wobei das erste Sensorelement (110) ein Hindernis in einer horizontalen Richtung (X-Achsen-Richtung) des Transportelements (1100) erfasst,
wobei das zweite Sensorelement (120) ein Hindernis in einer vertikalen Richtung (Y-Achsen-Richtung) des Transportelements (1100) erfasst,
**dadurch gekennzeichnet, dass**
das Arbeitselement (1200) ferner einen Arbeitsroboter (310), ein Magazinaufnahmeteil (320) und ein viertes Sensorelement (140), das mit dem Arbeitsroboter (310) verbunden ist, einschließt,
wobei das Magazinaufnahmeteil (320) ein Magazin (M) aufnimmt,
wobei der Arbeitsroboter (310) ein Gelenkteil (311) und ein Greifteil (312) einschließt,
wobei das vierte Sensorelement (140) die horizontale und vertikale Ausrichtung des Greifteils (312) und des Magazins (M) steuert, wenn das Greifteil des Arbeitsroboters (310) das Magazin (M) greift.

2. Mobiler Roboter nach Anspruch 1, wobei das Transportelement (1100) eine erste Seitenoberfläche, eine zweite Seitenoberfläche, eine dritte Seitenoberfläche, eine vierte Seitenoberfläche, eine erste Verbindungsoberfläche zwischen der ersten Seitenoberfläche und der zweiten Seitenoberfläche einschließt; und eine zweite Verbindungsoberfläche zwischen der ersten Seitenoberfläche und der dritten Seitenoberfläche,
wobei das erste Sensorelement (110) auf der ersten Verbindungsoberfläche und der zweiten Verbindungsoberfläche angeordnet ist,
wobei das zweite Sensorelement (120) auf der ersten Seitenoberfläche, der zweiten Seitenoberfläche, der dritten Seitenoberfläche und der vierten Seitenoberfläche angeordnet ist.

3. Mobiler Roboter nach Anspruch 2, wobei das erste Sensorelement (110) einen Lidarsensor einschließt, wobei das zweite Sensorelement (120) einen Laserabstandssensor einschließt.

4. Mobiler Roboter nach Anspruch 1, wobei das erste Sensorelement (110) konfiguriert ist, um ein Hindernis
- in einer horizontalen Ebene des mobilen Roboters (1000), und
- innerhalb eines Winkelbereichs von 180° bis 270° des ersten Sensorelements (110) zu erfassen.

5. Mobiler Roboter nach Anspruch 1, wobei das erste Sensorelement (110) konfiguriert ist, um ein Hindernis zu erfassen, das in einem Abstand von 0,05 m bis 25 m von dem mobilen Roboter (1000) beabstandet ist.

6. Mobiler Roboter nach Anspruch 1, wobei das zweite Sensorelement (120) konfiguriert ist, um ein Hindernis
- in einer vertikalen Ebene des mobilen Roboters (1000), und
- innerhalb eines Winkelbereichs von 0° bis 360° des zweiten Sensorelements (120) zu erfassen.

7. Mobiler Roboter nach Anspruch 1, wobei das zweite Sensorelement (120) konfiguriert ist, um ein Hindernis zu erfassen, das von dem mobilen Roboter (1000) in einem Abstand von 0,1 m bis 16 m beabstandet ist.

8. Mobiler Roboter nach Anspruch 1, ferner umfassend ein drittes Sensorelement (130), das an der ersten Seitenoberfläche des Transportelements (1100) angeordnet ist und eine Position des mobilen Roboters (1000) derart steuert, dass eine Abweichung zwischen den Zentrumskoordinaten des dritten Sensorelements (130) und den Zentrumskoordinaten der Anlage 40 mm oder weniger beträgt.

9. Mobiler Roboter nach Anspruch 8, wobei das dritte Sensorelement (130) von dem ersten Sensorelement (110) und dem zweiten Sensorelement (120) beabstandet ist.

10. Mobiler Roboter nach Anspruch 8, wobei das dritte Sensorelement (130) eine Vision-Kamera oder einen QR-Code einschließt.

11. Mobiler Roboter nach Anspruch 1, ferner umfassend eine Kommunikationseinheit (200), die an einer Seitenoberfläche des Transportelements (1100) angeordnet ist.

12. Mobiler Roboter nach Anspruch 1, ferner umfassend eine Ladeeinheit (400), die an mindestens einer Seitenoberfläche des Transportelements (1100) angeordnet ist.

13. Mobiler Roboter nach Anspruch 12, wobei die Ladeeinheit (400) geladen wird, wenn sich der mobile Roboter (1000) zu der Prozessanlage bewegt und einen Prozess durchführt.

## Revendications

1. Un robot mobile (1000) comprenant :
un élément de transport (1100) ; et
un élément de travail (1200) disposé sur l'élément de transport (1100),
dans lequel l'élément de transport (1100) comprend un premier élément capteur (110) disposé sur une surface latérale de l'élément de transport (1100) et un deuxième élément capteur (120) éloigné du premier élément capteur (110),
dans lequel le premier élément capteur (110) détecte un obstacle dans une direction horizontale (direction de l'axe X) de l'élément de transport (1100),
dans lequel le deuxième élément capteur (120) détecte un obstacle dans une direction verticale (direction de l'axe Y) de l'élément de transport (1100),
**caractérisé en ce que**
l'élément de travail (1200) comprend en outre un robot de travail (310), une partie d'accueil du magasin (320), et un quatrième élément capteur (140) combiné au robot de travail (310),
dans lequel la partie d'accueil du magasin (320) accueille un magasin (M),
dans lequel le robot de travail (310) comprend une partie d'articulation (311) et une partie de préhension (312),
dans lequel le quatrième élément capteur (140) contrôle l'alignement horizontal et vertical de la partie de préhension (312) et du magasin (M) lorsque la partie de préhension du robot de travail (310) saisit le magasin (M).

2. Le robot mobile selon la revendication 1, dans lequel l'élément de transport (1100) comprend une première surface latérale, une deuxième surface latérale, une troisième surface latérale, une quatrième surface latérale, une première surface de connexion entre la première surface latérale et la deuxième surface latérale ; et une deuxième surface de connexion entre la première surface latérale et la troisième surface latérale,
dans lequel le premier élément capteur (110) est disposé sur la première surface de connexion et la deuxième surface de connexion,
dans lequel le deuxième élément capteur (120) est disposé sur la première surface latérale, la deuxième surface latérale, la troisième surface latérale et la quatrième surface latérale.

3. Le robot mobile selon la revendication 2, dans lequel le premier élément capteur (110) comprend un capteur lidar, et le deuxième élément capteur (120) comprend un capteur de distance laser.

4. Le robot mobile selon la revendication 1, dans lequel le premier élément capteur (110) est configuré pour détecter un obstacle
- dans un plan horizontal du robot mobile (1000), et
- dans une plage angulaire de 180° à 270° du premier élément capteur (110).

5. Le robot mobile selon la revendication 1, dans lequel le premier élément capteur (110) est configuré pour détecter un obstacle situé à une distance de 0,05 m à 25 m du robot mobile (1000).

6. Le robot mobile selon la revendication 1, dans lequel le deuxième élément capteur (120) est configuré pour détecter un obstacle - dans un plan vertical du robot mobile (1000), et - dans une plage angulaire de 0° à 360° du deuxième élément capteur (120).

7. Le robot mobile selon la revendication 1, dans lequel le deuxième élément capteur (120) est configuré pour détecter un obstacle situé à une distance de 0,1 m à 16 m du robot mobile (1000) .

8. Le robot mobile selon la revendication 1, comprenant en outre un troisième élément capteur (130) disposé sur la première surface latérale de l'élément de transport (1100) et contrôlant la position du robot mobile (1000) de sorte que l'erreur entre les coordonnées du centre du troisième élément capteur (130) et les coordonnées du centre de l'installation soit de 40 mm ou moins.

9. Le robot mobile de la revendication 8, dans lequel le troisième élément capteur (130) est espacé du premier élément capteur (110) et du deuxième élément capteur (120).

10. Le robot mobile de la revendication 8, dans lequel le troisième élément capteur (130) comprend une caméra de vision ou un code QR.

11. Le robot mobile de la revendication 1, comprenant en outre une unité de communication (200) disposée sur une surface latérale de l'élément de transport (1100).

12. Le robot mobile de la revendication 1, comprenant en outre une unité de charge (400) disposée sur au moins une surface latérale de l'élément de transport (1100).

13. Le robot mobile de la revendication 12, dans lequel l'unité de charge (400) est chargée lorsque le robot mobile (1000) se déplace vers l'installation de traitement et effectue un procédé.
